# EUROPÄISCHE PATENTANMELDUNG

(11) **EP 1 662 251 A2**
(43) Veröffentlichungstag der Anmeldung: **31.05.2006**
(21) Anmeldenummer: 05001640.1
(22) Anmeldetag: 27.01.2005
(51) Int. Cl.: G01N 21/956

(54) **Optische Inspektionsvorrichtung für Substrate**

(30) Priorität: 24.11.2004 DE 102004056698
(71) Anmelder: Stratus Vision GmbH, 82116 Gräfelfing (DE)
(72) Erfinder: Stenger, Heinrich, 81243 München (DE)
(74) Vertreter: Baronetzky, Klaus

(57) **Zusammenfassung**

Die Erfindung betrifft eine Inspektionsvorrichtung, mit einem Inspektionskopf der relativ zu einer Führungsunterlage in mindestens zwei Richtungen beweglich ist. Die Führungsunterlage lagert ein zu inspizierendes Substrat, wobei das Substrat mindestens zwei aufgedruckte Schichten aufweist, die einander mindestens teilweise überlappend nacheinander aufgebracht sind. Der Inspektionskopf weist eine Beleuchtungsvorrichtung und eine Erfassungsvorrichtung auf, die von dem Substrat reflektierte elektromagnetische Strahlung erfasst und einer Auswertvorrichtung zuleitet, mit welcher Fehler des Substrat (30) erfassbar sind. Der Inspektionskopf (12) weist gegebenenfalls einen sich konisch aufweitenden Tunnel (24) auf, an dessen Innenumfang eine Vielzahl von Leuchtelementen angebracht sind, und dass die Erfassungsvorrichtung (14) eine Digitalkamera (18) mit einer Optik ist, die eine Auflösung von weniger als 30 Mikrometern auf dem Substrat (30) erfasst und dass durch die Bewegungsvorrichtung die Relativbewegung zwischen Führungsunterlage (32) und Inspektionskopf (12) während eines Aufnahmezyklus steuert, bei dem aneinander anschließende oder überlappende Einzelbilder zu einem Gesamtbild des Substrats (30) zusammenfügbar sind.

## Beschreibung

Die Erfindung betrifft eine Inspektionsvorrichtung, gemäß dem Oberbegriff von Anspruch 1.

Eine derartige Inspektionsvorrichtung wird eingesetzt, um die Qualität von insbesondere in Dickschichttechnik aufgebrachten Schaltkreisen zu prüfen. Derartige Schaltkreise werden regelmä-Big in einer Vielzahl, beispielsweise 20, von Schichten mittels Siebdrucktechnik aufgebracht. Hierbei ist es wichtig, dass nicht beispielsweise aufgrund von Maskenfehlern fehlerhafte Schichten aufgebracht werden.

Um dies zu prüfen, ist es bekannt geworden, mittels elektrischer Testausrüstung die Funktion der Schaltkreise im Einzelnen zu testen. Nachteilig hierbei ist es, dass meist alle Schichten aufgebracht werden müssen und dann die Prüfung vorgenommen werden kann. Wenn der Test Fehler ergeben hat, besteht lediglich die Möglichkeit, den betreffenden Chip zu verwerfen, mit den entsprechenden Kostennachteilen.

Ferner ist es auch bereits vorgeschlagen worden, während des Aufbringens der Schichten optische Prüfungen vorzunehmen. Diese können beispielsweise visuell, also über einen geschulten Bediener erfolgen. Es ist aber auch bekannt geworden, über geeignete optische Erfassungsvorrichtungen das Bild der gedruckten Schicht oder Schichten zu erfassen und mit einem Sollbild zu vergleichen. Wenn die Abweichung dann zu groß ist, wird der betreffende Chip ausgesondert.

Es sind zahlreiche Lösungen bekannt geworden, in welcher Weise derartige Inspektionsvorrichtungen realisiert und verbessert werden können. Ein Beispiel hierfür ist die US-PS 4,389,669. Bei dieser Lösung wird mit einer optischen Erfassungsvorrichtung, nämlich einem Mikroskop, unter Verwendung einer Kamera eine optische Prüfung vorgenommen, die dem Grunde nach auch für die Erfassung von Chips geeignet ist. Allerdings erfordert die dortige Lösung bei der Kundenforderung einer raschen und zuverlässigen Prüfung der elektronische Schaltkreise oder Chips einen erheblichen gerätetechnischen Aufwand.

Ein weiteres Beispiel für die Erfassung von elektronischen Schaltkreise mittels Kameras ist aus der US-PS 5,245,421 ersichtlich, wobei gemäß der US-PS 5,060,065 auch spezielle Beleuchtungsvorrichtungen eingesetzt werden können, um die Möglichkeiten der Erfassung zu verbessern.

Aus der US-PS 4,673,988 ist es schließlich bereits bekannt, eine Inspektionsvorrichtung unter Verwendung eines in Bildbereiche aufgeteilten Bildes zu realisieren. Dies geschieht über den dort vorgesehenen Bildprozessor, wobei das zu inspizierende Objekt in zwei Dimensionen bewegbar ist.

Den genannten Lösungen haftet der gemeinsame Nachteil an, dass ein vergleichsweise großer gerätetechnischer Aufwand erforderlich ist, aber dennoch die Auswertungsgeschwindigkeit zu wünschen übrig lässt, gerade wenn eine Vielzahl von Schichten eines Chips geprüft werden sollen. Zudem ist die Erfassungsgenauigkeit der bekannten Lösungen verbesserungswürdig, gerade dann, wenn eine Inspektionsvorrichtung für einen raschen Durchsatz mit einer geringen Auflösung konzipiert wurde, aber eine genauere Erfassung bei einer bestimmten Serie der Chips vorgenommen werden soll.

Daher liegt der Erfindung die Aufgabe zu Grunde, eine Inspektionsvorrichtung gemäß dem Oberbegriff von Anspruch 1 zu schaffen, die hinsichtlich des Durchsatzes, aber auch der Erfassungsgenauigkeit und -zuverlässigkeit weiter verbessert ist, wobei auch eine flexible Anpassung an unterschiedliche Anforderungen möglich sein soll.

Diese Aufgabe wird erfindungsgemäß durch Anspruch 1 gelöst. Vorteilhafte Weiterbildungen ergeben sich aus den Unteransprüchen.

Die erfindungsgemäße Lösung zeichnet sich durch eine besonders flexible und damit gut an unterschiedliche Erfordernisse anpassbare, aber dennoch zuverlässige Inspektionsmöglichkeit für Chips oder dergleichen aus. Durch die besondere Beleuchtungsvorrichtung mit einer Vielzahl von Leuchtelementen, die sich beispielsweise auch, in mehreren Farben gruppiert, um einen Tunnel herum anordnen, ist sichergestellt, dass eine intensive Beleuchtung zentral an der durch die Erfassungsvorrichtung betrachtete Stellung erfolgt, und zwar je nach Art der aufgebrachten Schicht. Hierdurch ist es nicht erforderlich, die bereits vorgeschlagene Schrägbeleuchtung mit ihren Nachteilen vorzusehen, und zwar auch dann nicht, wenn die Schichten reflektierend sind.

Gemäß einer modifizierten Ausführungsform entfällt der Tunnel, und die Beleuchtung wird durch eine an geeigneter Stelle gruppierte Beleuchtungsvorrichtung sichergestellt. Besonders günstig ist es jedenfalls, dass das Bild gestrobt werden kann, dass also die Belichtung der Digitalkamera durch die Steuerung der Beleuchtungsvorrichtung erfolgt, während der Verschluss der Digitalkamera während des Betriebs offen bleiben kann.

Die Reflektionen werden durch die allseits leicht schräg angeordneten Leuchtdioden, die symmetrisch das Licht der Erfassungsvorrichtung zuleiten, praktisch in ihrer Wirkung so abgeschwächt, dass die Erkennungsrate überraschend gut ist. Überraschend zeigt es sich, dass sich besonders gute Ergebnisse in Verbindung mit dem CCD-Sensor einen Digitalkamera erzielen lassen: Offenbar sind die in Digitalkameras verwendeten CCD-Elemente trotz geringerer Auflösung empfindlicher und damit selektiver, was die Erfassung von Fehlern in einem Raster angeht. In besonders günstiger Ausgestaltung der Erfindung wird nämlich dann ein Fehler angenommen, wenn drei einander benachbarte Pixel einen gegenüber dem Referenzbild abweichenden Wert anzeigen.

Besonders günstig ist es ferner, wenn durch die intensive Ausleuchtung, die aber dennoch eine leichte, aber nicht zu große Schrägstellung umfasst, auch bei hohen Auflösungen mit kurzer Belichtungszeit gearbeitet werden kann, so dass die Taktzeit für die Erfassung verbessert ist.

In einer erfindungsgemäßen besonders günstigen Ausgestaltung wird das erfasste Bild einem Framegrabber zugeleitet, der es an eine PC weiterleitet, und erst dort erfolgt dann mit einem geringen Zeitversatz die Fehlererkennung.

Durch diese Art Pipelining und Verteilung von Aufgaben lässt sich mit vergleichsweise preisgünstiger Technik ein guter Durchsatz erzielen, so dass es beispielsweise nicht erforderlich ist, den PC in Echtzeit zu betreiben.

Typischerweise werden aus Kostengründen eine Vielzahl von einander gleichen elektronischen Schaltungen auf einem gemeinsamen Substrat, zum Beispiel einem Wafer oder einem Keramiksubstrat, gefertigt. Beispielsweise können Keramiksubstrate auch Größen von 20 x 20 cm haben. Auf einem derartigen Substrat befinden sich dann beispielsweise 50 oder sogar 200 entsprechende elektronische Schaltkreise. Typischerweise ist nun die Größe (Länge x Breite) eines Schaltkreises unabhängig von der Aufnahme des Einzelbildes durch die erfindungsgemäße Digitalkamera. Erfindungsgemäß ist nun die Möglichkeit vorgesehen, mehrere Einzelbilder durch elektronische Aufbereitung passgenau zu einem Gesamtbild zusammenzufügen, so dass die Fehlererkennung wesentlich rascher erfolgen kann, als wenn für jede Überprüfung die Digitalkamera genau auf einen elektronischen Schaltkreis fokussiert werden müsste. Die Geschwindigkeit ist damit im Grunde unabhängig von der Größe der Schaltkreise und lediglich von der gewünschten Auflösung und der Substratlösung abhängig, was einen erheblichen Fortschritt gegenüber der bekannten Lösungen bedeutet.

In vorteilhafter Ausgestaltung werden die Einzelbilder im Flug aufgenommen, also während der Relativbewegung zwischen Digitalkamera und Substrat beziehungsweise dessen Führungsunterlage. Dies ist lediglich dann möglich, wenn die Belichtungszeit im Verhältnis zur Relativbewegung kurz ist, so dass hierdurch keine Unschärfen entstehen. Diese Lösung hat den Vorteil, dass kein "Nachzittern" beim Abbremsen des Linearantriebs eine Unschärfe auslösen kann, und dass der Antrieb weniger belastet wird und damit länger lebig ist.

Diese Lösung bedingt eine intensive Ausleuchtung, um eine kurze Belichtungszeit zu erhalten.

Gemäß einer alternativen Ausgestaltung ist es ohne weiteres möglich, die Bewegungsvorrichtung für jedes Einzelbild anzuhalten und dann das betreffende Einzelbild anzufertigen. Hierdurch sind geringere Anforderungen an die Belichtung und die Digitalkamera gegeben.

In einer weiteren besonders günstigen Ausgestaltung ist es vorgesehen, die Grundauflösung der Digitalkamera unabhängig von der zu erfassenden Auflösung beizubehalten. Die Anpassung kann entweder durch ein elektronisches Zoom oder bevorzugt durch ein echtes optisches Zoom in der Optik realisiert werden, so dass sich bei einer größeren Fehlertoleranz, also einer geringeren Pixelauflösung für die Fehler eine raschere Zykluszeit erzielen lässt.

Besonders günstig ist es, dass die Farbe beziehungsweise das emittierte Lichtspektrum der Einzel-Leuchtelemente an den Anwendungsfall ohne weiteres angepasst werden kann. Bevorzugt gehören zu den Leuchtelementen auch UV-Leuchtdioden oder -Laserdioden, die eine besonders günstige Kontrastwirkung für Goldschichten ermöglichen. Erfindungsgemäß besonders bevorzugt ist es auch, die Pulsbreite an die verwendeten Schichtmaterialen anzupassen und so eine Optimierung der Fehlererkennung vorzunehmen.

Besonders günstig ist es, dass die Inspektionsvorrichtung bei einer Auflösung von 10 Mikrometern auf dem Substrat ein Einzelbild von 30 x 30 mm in weniger als 10 Sekunden, insbesondere näherungsweise 4 Sekunden, inspiziert.

Es versteht sich, dass der erfindungsgemäße Tunnel nicht unbedingt konisch aufgeweitet sein muss. Ein zylindrischer Tunnel, an dessen Innenumfang die Leuchtelemente befestigt sind, ermöglicht es vielmehr, mit noch geringeren Abschattungen zu arbeiten.

Außerdem ist der Schrägstellungswinkel der von dem Substrat fern angeordneten Leuchtelemente größer, was in verschiedenen Anwendungsfällen günstig ist.

Weitere Vorteile, Einzelheiten und Merkmale ergeben sich aus der nachfolgenden Beschreibung zweier Ausführungsbeispiele der Erfindung anhand der Zeichnung.

Es zeigen:
- Fig. 1: eine erfindungsgemäße Inspektionsvorrichtung in einer Ausführungsform, und
- Fig. 2: eine modifizierte Ausführungsform eines Teils einer erfindungsgemäßen Inspektionsvorrichtung.

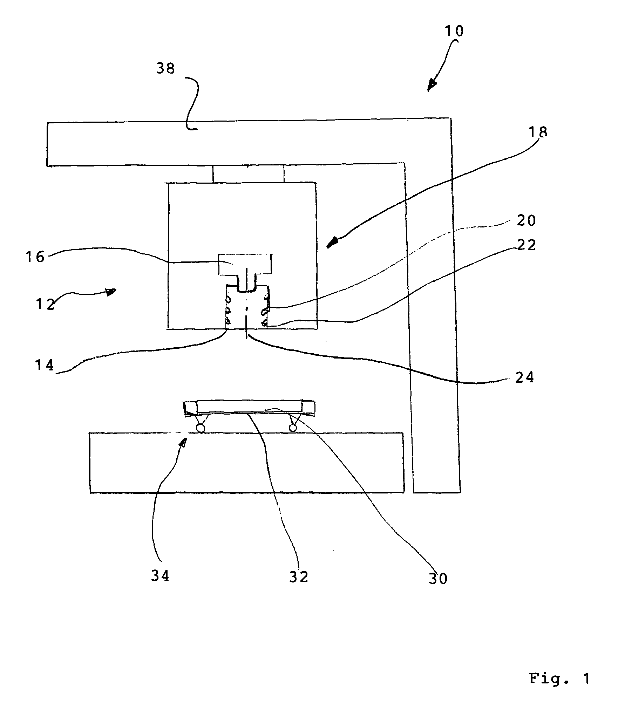

Die in Fig. 1 dargestellte Inspektionsvorrichtung 10 weist einen Inspektionskopf 12 auf, der seinerseits eine Beleuchtungsvorrichtung 14 und eine Erfassungsvorrichtung 16 aufweist.

Die Erfassungsvorrichtung 16 weist eine Digitalkamera 18 sowie gegebenenfalls eine zugehörige und nicht dargestellte Optik auf. Sie ist mit einer nicht dargestellten Auswertvorrichtung verbunden, die die Bilddaten nach Umwandlung in elektrische Signale aufbereitet und auswertet. Hierzu ist ein Framegrabber sowie ein PC angeschlossen, wobei der PC die einstellbare Fehlerauswertung vornimmt.

Die Beleuchtungsvorrichtung 14 besteht aus einer Vielzahl von bevorzugt leicht schräg gelagerten Leuchtdioden 20, 22, die in einem Tunnel 24 angeordnet sind. In dem dargestellten Ausführungsbeispiel ist der Tunnel zylindrisch ausgebildet und die Leuchtdioden 20, 22 sind an seinem Innenumfang an verschiedenen Reihen beziehungsweise Ringen angeordnet. Leuchtdioden verschiedener Farbe werden für die unterschiedlichen zu erfassenden Materialien eingesetzt.

Eine optische Achse 28 verläuft zentral durch den Tunnel 24 und trifft unten auf ein Substrat 30. Das Substrat 30 ist auf eine Führungsunterlage 32 gelagert. Die Führungsunterlage 32 ist in dem dargestellten Ausführungsbeispiel senkrecht zur Zeichnungsebene verfahrbar. Insgesamt ist die Führungsunterlage 32 relativ zu dem Inspektionskopf 12 in zwei Dimensionen über die Bewegungsvorrichtung 34 verfahrbar, wobei in dem dargestellten Ausführungsbeispiel hierzu der Inspektionskopf 12 gegenüber einem Rahmen 38 nach rechts und links verfahrbar ist. Es versteht sich, dass in beliebiger anderer Weise die erwünschte Bewegungsmöglichkeit des Substrats 30 gegenüber Inspektionskopf 12 realisierbar ist.

Der Inspektionskopf wird nun über Linearmotoren oder dergleichen der Bewegungsvorrichtung relativ zum Substrat 30 gleichmäßig bewegt, und es werden Einzelbilder aufgenommen. Die Einzelbilder werden dem Framegrabber über die Digitalkamera 18 zugeleitet, der die Datenaufbereitung vornimmt. Im angeschlossenen PC wird das gewünschte Gesamtbild zusammengefügt und erfasst.

Es versteht sich, dass anstelle der Erfassung und Auswertung des Gesamtbildes des Substrats auch Einzelbilder hinsichtlich der Fehler auswertbar sind, wobei jedoch erfindungsgemäß die Möglichkeit besteht, die Einzelbilder zu einem Gesamtbild zusammenzufügen.

Als Substrate können beliebige geeignete Substrate für elektronische Schaltkreise eingesetzt werden, beispielsweise aus Keramik, Keramikfibrit, Metall oder LTCC. Es sind auch glasfaserverstärkte Epoxidharzsubstrate prüfbar oder beliebig andere geeignete Substrate.

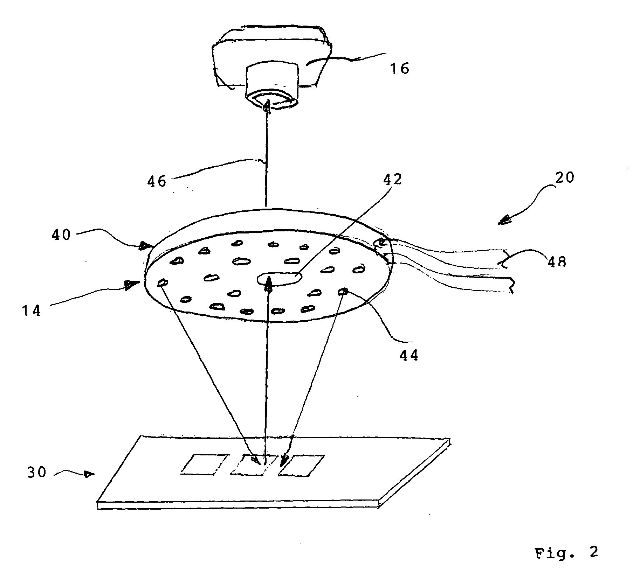

Die in Fig. 2 dargestellte Inspektionsvorrichtung 10 unterscheidet sich von der Inspektionsvorrichtung gemäß Fig. 1 durch eine andere Beleuchtungsvorrichtung 14. Es ist eine Art Schreibe 40 vorgesehen, die eine zentrale Öffnung 42 aufweist und an ihrer Unterseite eine Vielzahl von Lichtquellen beziehungsweise Leuchtelementen 44 trägt. Die Leuchtelemente 44 beaufschlagen das Substrat mit der gewünschten Belichtung. Das reflektierte Licht 46 wird durch die Öffnung 42 der Digitalkamera 16 zugeleitet.

Bei dieser Lösung erfolgt die Belichtung über die Leuchtelemente 44 gestrobt, also bei offenem Verschluss der Digitalkamera. Es können auch zahlreiche verschiedenfarbige Leuchtelemente 44 vorgesehen sein, die je nach Bedarf über die dort vorgesehenen Kabel 48 angesteuert werden. Die Kabel 48 können Glasfaserkabel sein, die den Leuchtelementen 44 Licht in an sich bekannter Form zuleiten, wobei die eigentliche Lichtquelle dann entfernt an geeigneter Stelle angeordnet sein kann. Alternativ können die Kabel 48 auch elektrische Anschlusskabel für Leuchtdioden sein, die dann an den aus Fig. 2 ersichtlichen Stellen angebracht sind. Besonders günstig ist es, dass die Inspektion mit dem erfindungsgemäßen Stroben, also der Steuerung der Belichtung über die Leuchtelemente 44 in einem Zug oder on the fly erfolgen kann. Dies ist auch besonders für die Realisierung von hohen Auflösungen günstig.

## Patentansprüche

1. Inspektionsvorrichtung, mit einem Inspektionskopf, der relativ zu einer Führungsunterlage in mindestens zwei Richtungen beweglich ist, welche Führungsunterlage ein zu inspizierendes Substrat lagert, wobei das Substrat mindestens eine aufgedruckte Schicht aufweist, wobei der Inspektionskopf eine Beleuchtungsvorrichtung und eine Erfassungsvorrichtung aufweist, die von dem Substrat reflektierte elektromagnetische Strahlung erfasst und einer Auswertvorrichtung zuleitet, mit welcher Fehler des Substrat (30) erfassbar sind, **dadurch gekennzeichnet, dass** die Erfassungsvorrichtung (14) eine Digitalkamera (18) mit einer Optik aufweist, die eine Auflösung von weniger als 200, insbesondere weniger als 30 Mikrometern auf dem Substrat (30) erfasst, und dass die Bewegungsvorrichtung die Relativbewegung zwischen Führungsunterlage (32) und Inspektionskopf (12) während eines Aufnahmezyklus steuert, bei dem aneinander anschließende oder überlappende Einzelbilder zu einem Gesamtbild des Substrats (30) zusammenfügbar sind.

2. Inspektionsvorrichtung nach Anspruch 1, **dadurch gekennzeichnet, dass** der Inspektionskopf (12) einen Tunnel (24) aufweist, der insbesondere Leuchtelemente der Beleuchtungsvorrichtung (14) für die Beleuchtung des Substrats (30) trägt.

3. Inspektionsvorrichtung nach Anspruch 1, **dadurch gekennzeichnet, dass** die Bilder im Flug aufnehmbar sind und die Bewegungsvorrichtung so gesteuert ist, dass aneinander anschließende oder leicht überlappende Einzelbilder bei gleichförmiger Bewegung der Bewegungsvorrichtung erfassbar sind.

4. Inspektionsvorrichtung nach einem der vorhergehenden Ansprüche, **dadurch gekennzeichnet, dass** die zu erfassende Fehlergröße durch Verstellung der Optik und/oder der Aufnahmeauflösung der Digitalkamera (18) vom Anwender der Inspektionsvorrichtung (10) einstellbar ist und bei gröberer Fehlergröße die Bildgröße jedes Einzelbildes vergrößerbar ist oder sein kann.

5. Inspektionsvorrichtung nach einem der vorhergehenden Ansprüche, **dadurch gekennzeichnet, dass** die Beleuchtungsvorrichtung (14) eine Durchlichteinheit aufweist, die unter der Führungsunterlage (32) angebracht ist sich gegebenenfalls mit dieser fortbewegt und mit welcher durchscheinende Substrate (30) inspizierbar sind und dass insbesondere unterhalb der Führungsunterlage (33) eine LED-Bett vorgesehen ist.

6. Inspektionsvorrichtung nach einem der vorhergehenden Ansprüche, **dadurch gekennzeichnet, dass** Substrate (30) als Keramiksubstrate, Keramikfibritsubstrate, Metall, LTCC-Substrate und/oder glasfaserverstärkte Epoxidharzsubstrate ausgebildet sind, die in Mehrschichttechnik (Multilayer) im Siebdruck bedruckbar sind.

7. Inspektionsvorrichtung nach einem der vorhergehenden Ansprüche, **dadurch gekennzeichnet, dass** die Inspektionsvorrichtung (10) Teil einer Erzeugungsanlage für bedruckte Substrate (30) ist, in welcher die teilweise bedruckten Substrate (30) der Inspektionsvorrichtung (10) nach Drucken mindestens einer Sicht zuführbar, dann wieder bedruckbar und dann erneut der Inspektionsvorrichtung (10) zyklisch zuführbar ist, bis sämtliche Schichten inspiziert sind.

8. Inspektionsvorrichtung nach Anspruch 1, **dadurch gekennzeichnet, dass** nach der Inspektion durch die Inspektionsvorrichtung (10) jede Schicht zyklisch in einem Trockenofen oder Brennofen einbrennbar ist.

9. Inspektionsvorrichtung nach einem der vorhergehenden Ansprüche, **dadurch gekennzeichnet, dass** in Anpassung an die verschiedenen Materialien der Schichten die Farbe der Beleuchtungsvorrichtung (14) einstellbar ist, wobei die Beleuchtungsvorrichtung (14) insbesondere eine Vielzahl von LEDs oder Laserdioden aufweist.

10. Inspektionsvorrichtung nach einem der Ansprüche 1 bis 8, **dadurch gekennzeichnet, dass** die Beleuchtungsvorrichtung (14) einen Lichtleiter, insbesondere ein Glasfaserkabel, aufweist und dass zwischen der Beleuchtungsvorrichtung und dem Substrat (30) mindestens eine Linse zur Erhöhung der Leuchtdichte angeordnet ist.

11. Inspektionsvorrichtung nach einem der vorhergehenden Ansprüche, **dadurch gekennzeichnet, dass** die Beleuchtungsvorrichtung (14) eine Taktsteuerung aufweist, mit welcher die einzelnen Leuchtelemente der Beleuchtungsvorrichtung (14) im Impulsbetrieb ansteuerbar sind.

12. Inspektionsvorrichtung nach einem der vorhergehenden Ansprüche, **dadurch gekennzeichnet, dass** die Beleuchtungsvorrichtung (14) einen Lichtimpuls zur Ausleuchtung der betreffenden Aufnahme der Digitalkamera (18) auflöst, der mit der Aufnahmesteuerung der Digitalkamera (18) synchronisiert ist.

13. Inspektionsvorrichtung nach einem der vorhergehenden Ansprüche, **dadurch gekennzeichnet, dass** eine Digitalkamera zur Erfassung des Bildes des Substrats vorgesehen ist, deren Verschluss offen ist und dass die digitale Belichtung durch die Steuerung der Beleuchtungsvorrichtung erfolgt.

14. Inspektionsvorrichtung nach einem der vorhergehenden Ansprüche, **dadurch gekennzeichnet, dass** die Leuchtelemente der Beleuchtungsvorrichtung (14) in einem sich in einem Winkel von 0° bis 50°, insbesondere etwa 20° konisch aufweitenden Tunnel (24) angeordnet sind und insbesondere mindestens teilweise dem Substrat (30) zugewandt sind.

15. Inspektionsvorrichtung nach einem der vorhergehenden Ansprüche, **dadurch gekennzeichnet, dass** an die Digitalkamera (18) ein Framegrabber angeschlossen ist, dessen Ausgang mit einem PC verbunden ist, der die Fehlererkennung vornimmt.

16. Inspektionsvorrichtung nach einem der vorhergehenden Ansprüchen, **dadurch gekennzeichnet, dass** mindestens zwei aufgedruckte Schichten auf dem Substrat (30) vorgesehen sind, die sich insbesondere mindestens teilweise überlappend und nacheinander aufgebracht sind.

17. Inspektionsvorrichtung nach einem der vorhergehenden Ansprüche, **dadurch gekennzeichnet, dass** der Tunnel (24) sich zum Substrat mindestens teilweise aufweitet, insbesondere konisch aufweit und dass an dem Innenumfang des Tunnels (24) eine Vielzahl von Leuchtelementen angebracht sind.
